# FASCICULE DE BREVET EUROPEEN

(11) **EP 2 665 601 B1**
(45) Date de publication et mention de la délivrance du brevet: **25.04.2018**
(21) Numéro de dépôt: 12705335.3
(22) Date de dépôt: 17.01.2012
(51) Int. Cl.: B32B 17/06, B32B 17/10, B32B 17/12, G02B 6/00, B60Q 3/208, B60Q 3/64, F21V 8/00

(54) **VITRAGE LUMINEUX**
LEUCHTENDE GLASSCHEIBE
LUMINOUS GLASS PANEL

(30) Priorité: 21.01.2011 FR 1150478
(43) Date de publication de la demande: 27.11.2013
(73) Titulaire: Saint-Gobain Glass France, 92400 Courbevoie (FR)
(72) Inventeur: VERGER, Arnaud, F-75013 Paris (FR); VERMERSCH, François-Julien, F-75014 Paris (FR); LECAMP, Guillaume, F-75018 Paris (FR); SOLARSKI, Samuel, F-59110 la Madeleine (FR); VERRAT-DEBAILLEUL, Adèle, F-60150 Villers-sur-Coudun (FR); MOTTELET, Béatrice, F-60200 Compiegne (FR); KLEO, Christophe, F-60350 Attichy (FR); BAUERLE, Pascal, F-80700 Roye (FR); PIROUX, Fabienne, 60200 Compiegne (FR); RICHARD, Alexandre, F-75019 Paris (FR)
(74) Mandataire: Saint-Gobain Recherche
(86) Numéro de dépôt international: PCT/FR2012/050101
(87) Numéro de publication internationale: WO 2012/098330

(56) Documents cités:
- EP-A1- 0 919 766
- WO-A1-2007/077099
- WO-A1-2008/035010
- WO-A1-2008/061789
- DE-A1- 10 123 263
- DE-A1- 10 206 613
- DE-A1-102005 036 869
- DE-A1-102007 041 394
- US-A1- 2006 087 864
- US-A1- 2007 098 969

## Description

La présente invention est relative à un vitrage lumineux (ou « éclairant »), plus particulièrement pour véhicule, notamment un vitrage automobile à diodes électroluminescentes. Il est également utilisable dans le bâtiment ou toute application de lampe plane ou surfacique.

Les diodes électroluminescentes ou DEL (LED en anglais) ont à l'origine été employées pour constituer des lampes ou voyants d'appareils électriques et électroniques, et assurent depuis quelques années l'éclairage de dispositifs de signalisation (feux de signalisation,...), de clignotants ou feux de position de véhicules automobiles, de lampes portatives ou de balisage. L'intérêt des diodes est leur longue durée de vie, leur efficacité lumineuse, leur robustesse, leur faible consommation énergétique et leur compacité, rendant les appareillages les employant davantage pérennes, et nécessitant un entretien réduit.

Plus récemment, les diodes électroluminescentes ont été utilisées dans des vitrages éclairants pour bâtiments ou pour l'automobile. Dans ce dernier domaine, il est connu par exemple des toits panoramiques à éclairage par diodes électroluminescentes comme décrit dans le document WO2010049638. La lumière émise par les diodes est introduite dans le vitrage dans une partie de son épaisseur formant guide, par un ou plusieurs de ses bords latéraux formant la tranche, la lumière étant extraite du vitrage en l'une et/ou l'autre de ses faces principales (face(s) « lumineuse(s) »). La partie formant guide est généralement en forme de plaque mince constituée d'un matériau transparent, et l'extraction en une face ou surface du vitrage se fait en créant une surface d'extraction sur une face ou dans l'épaisseur du guide, par sablage, attaque acide ou gravure, ou par revêtement par une couche diffusante de type émail, déposée par sérigraphie, comme celle décrite dans le document FR2809496.

Néanmoins, dans le domaine automobile notamment, chacune de ces diverses méthodes présente des limites, les rendant le cas échéant peu compatibles avec certaines productions ou exigences.

En particulier, le sablage, l'attaque acide ou la gravure ne conviennent généralement qu'au traitement de petites surfaces et/ou nécessitent des temps de traitement longs incompatibles avec des lignes automobiles pour moyennes ou grandes séries, ou encore peuvent poser des risques de fragilisation du verre utilisé. L'émaillage, s'il conduit à une bonne homogénéité de la lumière, pose lui en revanche des problèmes d'adhésion et de dégradation de la couche d'émail lorsqu'elle est en face extérieure et peut s'avérer incompatible ou interférer avec certaines fonctions recherchées, en particulier pose problème pour les vitrages à couches (tels que les vitrages comportant une couche de basse émissivité) fréquemment utilisés dans le domaine automobile.

La présente invention a donc cherché à mettre au point un nouveau vitrage lumineux ou éclairant, en particulier à diodes électroluminescentes, plus adapté au domaine de l'automobile notamment, en particulier un vitrage efficace en terme d'extraction sans pour autant présenter les inconvénients ou incompatibilités vues précédemment, ce vitrage étant simple, efficace et compatible avec les exigences industrielles (facilité et rapidité de production, fiabilité,...), et élargissant avantageusement la gamme des applications possibles.

Ce but est atteint selon l'invention par l'utilisation, comme moyen (en particulier couche) d'extraction, d'une structure fibreuse ou « textile » (formée de fibres), en particulier formée d'au moins une couche ou nappe textile. L'invention concerne cette structure avec son utilisation comme moyen d'extraction pour réaliser un vitrage lumineux, et concerne le vitrage ainsi réalisé comprenant :
- au moins un substrat, formé d'au moins un élément verrier (inorganique et/ou organique), préférentiellement transparent, en particulier d'au moins une feuille (notamment de verre ou plastique) transparente,
- au moins une source de rayonnement (en particulier dans le visible et/ou dans l'ultraviolet),
- au moins un moyen (ou zone ou surface) d'extraction du rayonnement (ledit moyen d'extraction étant agencé de façon à créer une zone lumineuse sur au moins l'une des faces du substrat (en particulier face principale)), ce moyen d'extraction étant formé par au moins une structure fibreuse comme précédemment évoqué.

Le substrat présente généralement une tranche, deux faces principales (faces externes de plus grandes dimensions) et une épaisseur donnée. Il peut être formé d'une ou plusieurs feuilles et constitue ou comprend généralement une partie formant guide (par exemple au moins une feuille de verre transparente) pour guider (généralement par réflexions internes, le cas échéant totales, et dans l'épaisseur du substrat ou de ladite partie) le rayonnement émis par la ou les sources lumineuses (sources de rayonnements).

Le substrat (de même que le guide) peut être plan, mais peut aussi être bombé ou galbé (cas notamment des vitrages de véhicules). Il peut être parallélépipédique, avec des feuilles ou des faces principales rectangulaires, carrées ou même de toute autre forme (ronde, ovale, polygonale...). Il peut être de différentes tailles, et notamment de grande taille, par exemple de surface supérieure à 0,5 ou 1 m². Son épaisseur est généralement d'au moins 1 mm, en particulier de 2 à 20 mm, par exemple entre 3 et 5 mm, celle de la partie formant guide étant généralement d'au moins 0.3 mm, en particulier entre 0.7 et 3 mm, et n'excédant pas non plus 20 mm.

Le substrat (de même que le guide) est préférentiellement formé d'éléments (feuilles, verres, couches...) ou matériaux transparents (en particulier verriers, minéraux ou organiques), clairs ou teintés, pouvant être assemblés le cas échéant à chaud ou à froid, notamment par laminage, collage, etc. Par « transparent » on entend une transmission lumineuse d'au moins 3% au moins dans les domaines (utiles) de longueurs d'onde entre 400 nm et 800 nm.

Généralement, le substrat comprend une ou plusieurs feuilles en verre minéral (d'épaisseur de l'ordre de 0.7 à 6 mm ou plus), le verre minéral présentant de multiples atouts, en particulier une bonne résistance à la chaleur (il peut ainsi être proche des sources de rayonnements, par exemple des diodes, malgré le fait qu'elles constituent des points chauds ; il répond également aux besoins des normes de sécurité au feu) et une bonne résistance mécanique (il présente ainsi une facilité de nettoyage et résiste à la rayure). Ce verre minéral peut (selon le rendu esthétique, l'effet optique souhaité, la destination du vitrage, etc.) être un verre clair (transmission lumineuse T_{L} supérieure ou égale à 90% pour une épaisseur de 4 mm), par exemple un verre de composition standard sodocalcique comme le Planilux® de la société Saint-Gobain Glass, ou extra-clair (T_{L} supérieure ou égale à 91,5%), par exemple un verre silico-sodo-calcique avec moins de 0,05% de Fe III ou de Fe₂O₃ comme le verre Diamant® de Saint-Gobain Glass, ou Optiwhite® de Pilkington, ou B270® de Schott, ou d'autre composition décrite dans le document WO04/025334 ; le verre peut également être plus sombre, de même qu'il peut être neutre (sans coloration), ou (légèrement) teinté ou coloré (verre VENUS ou TSA de la société Saint-Gobain Glass, etc) ; il peut être lisse ou texturé (verre Albarino® de la société Saint-Gobain Glass, etc.), avoir subi un traitement chimique ou thermique du type durcissement, recuit ou trempe (pour une meilleure résistance mécanique notamment) ou bombage, et est généralement obtenu par procédé float. Il peut aussi s'agir le cas échéant d'une vitrocéramique, de préférence faiblement opaque, en particulier claire, par exemple la vitrocéramique KeraLite de la société Eurokera. Dans la présente description, en l'absence de précision, on entend par la suite par « verre » un verre minéral.

Outre des éléments en verre minéral (ou éventuellement alternativement), le substrat peut également contenir des éléments à base de matériaux organiques, par exemple en matière plastique transparente, par exemple de type polycarbonate (PC), polyvinylbutyral (PVB), polyoléfine telle que polyéthylène ou polypropylène, poly(téréphtalate d'éthylène), polyuréthane (PU), polymère acrylique tel que poly(méthacrylate de méthyle) (PMMA), polytetrafluoroethylene (PTFE), ethylene tetrafluoroethylene (ETFE), résine ionomère, copolymère, etc. Le cas échéant, le vitrage (ou substrat ou guide) pourrait être essentiellement plastique (feuille(s) organique(s), par exemple en PC), pour gagner en compacité et/ou en légèreté, ou pour permettre des formes plus diverses (généralement il comprend au moins une feuille de verre minéral comme indiqué précédemment).

Les éléments verriers organiques ou minéraux du substrat (éventuellement du guide) peuvent, le cas échéant, former un vitrage feuilleté et/ou éventuellement multiple (par exemple un double vitrage). Dans le cas d'un feuilleté, le substrat (et/ou le vitrage et/ou le guide) comprend au moins un intercalaire de feuilletage tel qu'un film plastique, avantageusement transparent (notamment en PVB ou PU (souple) ou thermoplastique sans plastifiant (copolymère éthylène/acétate de vinyle (EVA), etc.), chaque intercalaire ayant par exemple une épaisseur entre 0,2 mm et 1,1 mm, notamment 0,38 et 0,76 mm.

Par exemple, le vitrage peut comprendre (comme substrat ou partie de substrat ou guide) un feuilleté formé d'une première feuille transparente en verre minéral ou éventuellement organique, d'un intercalaire organique (par exemple un PVB transparent, teinté ou non) et d'une deuxième feuille en verre minéral ou organique, la feuille placée du côté prévu pour l'extraction de lumière étant préférentiellement une feuille de verre claire, l'autre feuille et/ou l'intercalaire pouvant être clair(s) et/ou plus sombre(s) ou teinté(s) et/ou intégrer une couche décorative et/ou fonctionnelle comme indiqué ultérieurement (par exemple une couche anti infrarouge, etc.), notamment pour préserver de la chaleur venant du soleil.

Dans le cas, éventuellement, d'un vitrage (ou substrat) multiple, le substrat/le vitrage présente un espace intérieur sous vide ou rempli avec une lame de gaz (air, gaz rare ou inerte, argon par exemple, etc), l'espace interne présentant par exemple une hauteur inférieure à 10 mm. Un espaceur, notamment en périphérie du vitrage, délimite par exemple l'espace interne, cet espaceur pouvant être un profilé, le cas échéant mononolithique, en particulier un cadre (notamment de section en C, fermée, carrée ou rectangulaire), et loger le cas échéant un dessicant ; l'espace interne peut par ailleurs être délimité par un système d'étanchéité périphérique, par exemple de type mastic combiné à du butyle comme dans le brevet WO0179644.

Alternativement à une structure feuilletée ou multiple, le vitrage (respectivement le substrat et/ou le guide) peut ne comprendre qu'un substrat simple ou monolithique (par exemple une feuille).

Tout comme le substrat qui l'incorpore, le guide (ou partie du substrat guidant le rayonnement émis par la/les sources ou "guide d'onde")) est doté d'une tranche et de deux faces principales et peut comprendre ou être constitué d'au moins une feuille de verre, et/ou éventuellement d'au moins une feuille de plastique (PC, PMMA,...); éventuellement il pourrait être feuilleté ou multiple. Il peut être mince ou épais (notamment jusqu'à 20 mm) et est préférentiellement transparent. Il peut être teinté, mais est de préférence clair ou extraclair. Pour limiter les pertes du rayonnement guidé, le guide peut être par exemple un verre présentant un coefficient d'absorption linéique inférieur à 2,5 m⁻¹, de préférence inférieur à 0,7 m⁻¹ à la longueur d'onde du rayonnement guidé. De préférence, le facteur de transmission (perpendiculairement aux faces principales) autour du pic du rayonnement est supérieur ou égal à 50%, notamment supérieur ou égal à 70%, voire supérieur ou égal à 80%.

Le rayonnement est guidé dans une partie ou l'ensemble du substrat (dans une feuille alors appelée feuille guide d'onde, ou éventuellement plusieurs feuilles ou couches si elles ont des indices optiques proches (la différence entre les indices n'excédant pas 0.03 de préférence)). Par exemple, dans le cas d'un feuilleté comprenant un verre clair, un verre plus sombre et un intercalaire de feuilletage neutre, le guide peut être constitué du verre clair, placé du côté où l'on souhaite réaliser l'extraction de lumière, ou éventuellement peut être l'ensemble verre clair et intercalaire de feuilletage d'indices de réfraction proches.

Comme défini selon l'invention, le vitrage comprend également au moins une source de rayonnement (ou source lumineuse) couplée au guide pour une propagation de la lumière (par réflexion totale interne) à l'intérieur du guide (dans l'épaisseur), avantageusement associée ou couplée à la tranche du guide (dans un autre mode, elle pourrait éventuellement être associée ou couplée à l'une des faces principales (en particulier logée dans une cavité ou une rainure)), le moyen d'extraction (de la lumière issue de la source/du rayonnement guidé) étant généralement sur l'une des faces en particulier principales ou dans l'épaisseur du guide, comme explicité ultérieurement, pour une sortie d'au moins une partie de la lumière par l'une (au moins) des faces principales.

On peut utiliser une ou plusieurs sources de lumière (identiques ou non), par exemple électriques et/ou constituées de dispositif(s) électroluminescent(s) (DEL, ...). La ou les sources de lumière peuvent être mono- (émettant dans le bleu, vert, rouge, etc) ou polychromatiques, ou être adaptées ou combinées pour produire par exemple une lumière blanche, etc ; elles peuvent être continues ou discontinues, etc.

Le ou les rayonnements, injectés dans le vitrage, peuvent notamment être émis dans le visible et/ou l'UV (de préférence proche UV), le rayonnement pouvant être converti en visible dans ce dernier cas en utilisant des moyens de conversion de lumière UV en visible, par exemple par passage dans au moins une couche de luminophores associée aux sources ou déposée sur la tranche ou une face (notamment d'extraction) du substrat, au moins une source étant disposée afin de permettre (en combinaison avec les autres éléments du vitrage) l'éclairage d'au moins une zone d'une face (généralement principale) que l'on cherche à éclairer.

De préférence, le vitrage selon l'invention est un vitrage lumineux à éclairage par la tranche, la ou les sources lumineuses étant disposées le long de la tranche (au bord du vitrage) du substrat (notamment de sa partie formant guide), cette ou ces sources pouvant être un tube néon classique, des diodes alignées (DEL/LEDs), plus ou moins espacées, une ou des fibres optiques (le long du bord d'injection du guide avec injection de lumière par extraction latérale de la fibre), etc.

La tranche, le coin ou le bord d'une face d'un élément du substrat/du guide peut comporter un évidement où sont placées les sources ou puces (on peut par exemple découper (avant trempage) le bord d'une feuille d'un vitrage simple ou feuilleté pour y loger des diodes) et/ou celles-ci peuvent être collées, notamment sur la tranche (on choisit alors une colle avec un indice optique de réfraction intermédiaire entre l'indice du guide et celui du milieu externe ou de la lentille par exemple). La zone évidée peut former une rainure le long du guide, pour loger une pluralité de sources, rainure non débouchante ou débouchante sur au moins un côté pour faciliter un montage par le côté. Les sources peuvent être dans un moyen de protection et/ou de maintien à l'intérieur de la zone évidée, notamment un profilé en U, fixé à la tranche de couplage par collage, encliquetage, par des boulons etc, et occuper une partie ou la majorité de la zone évidée.

La tranche peut être biseautée (angle d'au moins 45°, en particulier d'au moins 80°, et inférieur à 90°) pour rediriger les rayonnements sur une plus large zone d'extraction, et/ou la tranche portant des sources et/ou celle opposée peut être rendue réfléchissante, par exemple grâce à un ruban adhésif métallique ou à un dépôt d'argent (protégé par un vernis contre l'oxydation) ou comporter un miroir, pour assurer un recyclage optimal du rayonnement guidé.

Avantageusement (pour des raisons notamment de taille, environnementales, de chauffe...), on utilise des sources de lumière quasi ponctuelles (telles que LEDs), ces sources étant avantageusement placées le long de la tranche du guide (de manière à éclairer le guide par sa tranche), ce mode étant simple, économique et performant.

Les diodes peuvent être de simples puces semi-conductrices (sans encapsulation ou lentille de collimation), de taille par exemple de l'ordre de la centaine de µm ou d'un ou quelques millimètres (par exemple 1mm de largeur, 2,8 mm de longueur et 1,5 mm de hauteur). Elles peuvent aussi comprendre une enveloppe protectrice, provisoire ou non, pour protéger la puce lors de manipulations ou pour améliorer la compatibilité entre les matériaux de la puce et d'autres matériaux et/ou être encapsulées (par exemple encapsulation de faible volume de type 'SMD' (« surface monted device »), avec une enveloppe, par exemple en résine type époxy ou nylon ou PMMA, encapsulant la puce et ayant des fonctions diverses : protection contre l'oxydation et l'humidité, rôle diffusant, de focalisation, ou collimation, conversion de longueur d'onde...).

Le nombre total de diodes est défini par la taille et la localisation des zones à éclairer, par l'intensité lumineuse souhaitée et l'homogénéité de lumière requise.

Les diodes peuvent être avec l'une et/ou l'autre de ces caractéristiques: avec des contacts électriques sur les faces opposées ou sur une même face, à émission latérale (parallèlement aux contacts électriques), à direction principale d'émission perpendiculaire ou oblique par rapport à la face émettrice de la puce pour favoriser le guidage, avec deux directions principales d'émission obliques par rapport à la face émettrice de la puce, donnant une forme d'aile de chauve-souris (« batwing »), les deux directions étant par exemple centrées sur des angles entre 20° et 40° et entre -20° et -40° ou sur des angles entre 60° et 85° et entre -60° et -85°, inversées, de diagramme d'émission lambertien, etc.

La puissance de chaque diode est généralement inférieure à 1 W, notamment inférieure à 0,5 W. Chaque diode peut être de « haute puissance » (supérieure à 0,2 W) et/ou de luminosité supérieure à 5 lumens, et/ou on peut préférer éviter des points lumineux intenses et choisir par exemple une diode de type « batwing ».

Généralement, les diodes sont choisies avec la même direction principale d'émission (pour plus de simplicité), et avec le même spectre, mono ou polychromatique (pour un éclairage uniforme). Elles ont généralement (chacune) une direction principale d'émission sensiblement parallèle aux faces principales, notamment jusqu'à +5° ou -5° par rapport à la face d'extraction, le vitrage pouvant également comprendre au moins un réflecteur pour les diodes, agencé pour rediriger de la lumière vers la couche extractrice et/ou sur les faces internes ou externes du vitrage.

Les diodes peuvent être (pré)assemblées sur une ou des embases (nommées PCB pour Printed Circuit Board en anglais) ou supports, avec des pistes d'alimentation électrique, ces embases ou ces supports pouvant être fixées à d'autres supports (profilés, etc.). Dans le cas d'un vitrage comportant deux éléments verriers en regard, solidaires et espacés, les diodes (fixées le cas échéant sur support(s)/embase(s)), peuvent être solidaires d'un espaceur des éléments, périphérique ou non (par exemple un cadre périphérique), en contact le cas échéant avec un ou des moyens de scellement. Chaque embase/support de diodes peut s'étendre en bordure du vitrage et être fixé (notamment à une feuille du vitrage et/ou au guide) par pincement, chaussage, clipsage, vissage, colle ou ruban adhésif double face, etc. L'embase/le support est généralement mince, notamment d'épaisseur inférieure ou égale à 3 mm, voire 1 mm, voire 0,1 mm ou inférieur le cas échéant à l'épaisseur d'un intercalaire de feuilletage. Plusieurs supports peuvent être prévus, notamment si les zones à éclairer sont très distantes entre elles. L'embase peut être en matériau souple, diélectrique ou électroconducteur (métallique tel qu'aluminium etc), être composite, plastique, etc. Les diodes peuvent être soudées sur des pistes isolées électriquement de l'embase, et/ou sur des surfaces dissipatrices de chaleur ("thermal pad") sur des embases plastiques, ou un matériau isolant électrique et conducteur thermique (colle, ruban, scotch, adhésif double face, thermiquement conducteur, graisse thermique, etc.) peut fixer ou être intercalé pour une meilleure dissipation et efficacité lumineuse et pour la pérennité des diodes. Pour une ou des embases (ou supports) de diodes de longueur totale L0, la puissance totale du groupe de diodes est préférentiellement inférieure ou égale à 30 [W/m] x L [m] pour limiter la chauffe et donc pérenniser les diodes. Pour une meilleure efficacité lumineuse, l'embase peut aussi porter une surface diffusante (plane ou inclinée) autour des diodes, par exemple laque ou peinture, et/ou un réflecteur blanc, etc.

Le vitrage peut aussi comprendre des moyens d'étanchéité au(x) fluide(s) aptes à protéger les puces et/ou le support des puces peut être perforé pour qu'une colle adhésive noie les puces.

Le vitrage peut comprendre plusieurs groupes de diodes (ainsi qu'une ou plusieurs zones lumineuses). Des sources lumineuses identiques ou émettant différentes longueurs d'ondes peuvent aussi être associées selon des compositions et/ou concentrations variables, de manière à former des couleurs différentes ou des zones lumineuses de formes diverses.

Le vitrage peut aussi comprendre une diode réceptrice de signaux de commande (notamment dans l'infrarouge), pour télécommander les diodes d'éclairage, et/ou ces dernières peuvent être couplées à des moyens de pilotage permettant d'émettre en permanence ou par intermittence, avec différentes intensités, une couleur donnée ou différentes couleurs, etc.

D'autres types de sources que les diodes peuvent éventuellement être utilisées, le cas échéant dans un évidement à cet effet, ou sur un élément rapporté. Ces autres sources de lumière peuvent être directement sur l'une des faces du substrat (par exemple principale), ou être collées ou feuilletées avec un autre substrat, notamment transparent (verre...), à l'aide d'un intercalaire de feuilletage, notamment extraclair.

Par exemple, ou peut utiliser une couche photoluminescente, notamment sensiblement transparente, et excitable dans l'UV (en particulier proche UV - environ 360 à 400 nm) ou dans le visible, de préférence associée à un dispositif électroluminescent (diodes DEL, couche électroluminescente...) producteur de rayonnement excitateur, par exemple à base de particules luminophores (CaS:Eu, Tm ²⁺ , SrAl₂O₄:Eu²⁺, Y₃Al₅O₁₂:Ce, etc.), éventuellement associées pour produire une lumière blanche, ou de particules dites « core-shell » (par exemple ZnS pour la coquille et CdSe pour le coeur), ces particules pouvant être en suspension dans une matrice (par exemple inorganique, comprenant un produit de polymérisation d'alkoxyde de silicium tel que tétraéthoxysilane (TEOS), tétraméthoxysilane (TMOS), méthyltriéthoxysilane (MTEOS), etc.), la couche photoluminescente pouvant le cas échéant convertir la longueur d'onde d'autre(s) source(s) (par exemple UV des diodes en visible).

Quelle que soit la source lumineuse, l'épaisseur de la source est avantageusement faible, pouvant descendre jusqu'à quelques nanomètres ou dizaines de nanomètres notamment.

Dans un mode de réalisation avantageux, un ou plusieurs capteurs liés à l'environnement et/ou au vitrage peuvent être associés aux sources de rayonnement et/ou au système d'alimentation dudit vitrage. On peut utiliser par exemple un détecteur de luminosité (photodiode, etc.), un capteur de température (extérieur ou intégré, sur le verre ou les sources lumineuses), le capteur utilisé contrôlant par exemple l'alimentation des sources lumineuses via un calculateur ou unité centrale. On peut définir une valeur de mesure du capteur (luminosité maximale par exemple) au-delà de laquelle le vitrage cesse d'opérer une de ses fonctions (extraction de lumière ou activation des sources lumineuses notamment). Pour une valeur supérieure par exemple, l'alimentation du vitrage est bloquée et pour une valeur inférieure, le vitrage ou une de ses fonctions (par exemple son niveau de luminosité) peut être contrôlé(e) via l'information reçue du ou de(s) capteurs. La fonction du vitrage peut aussi être « forcée » par l'utilisateur en désactivant les capteurs.

Les capteurs peuvent être à l'intérieur (par exemple du véhicule) ou à l'extérieur. La gestion du vitrage en fonction de l'environnement extérieur permet par exemple d'améliorer la durabilité des sources lumineuses et autres composants (polymères, composants électroniques...), la limitation de leur fonctionnement dans des conditions de luminosité et/ou de température élevées permettant notamment de réduire de manière significative (entre 10 et 20°C au minimum) les températures maximales auxquelles peuvent être exposées les sources lumineuses pendant l'utilisation du produit, tout en conservant les fonctions du vitrage lumineux. Ce couplage permet également d'adapter automatiquement l'intensité d'éclairage du vitrage aux conditions de luminosité extérieures, sans que l'utilisateur n'intervienne.

Pour un vitrage de véhicule, l'alimentation des sources de lumière peut être par exemple contrôlée par le calculateur central du véhicule autorisant ou non leur allumage en fonction de l'information reçue du capteur de lumière placé par exemple dans la partie haute du pare-brise ou sur un vitrage tel qu'un toit éclairant. Par forte luminosité (jour), la valeur de luminosité dépasse la valeur maximale, n'entraînant pas l'allumage des sources de lumière ; en conditions de faible luminosité (nuit), la valeur maximale n'est pas atteinte, l'activation des sources est alors opérée. L'allumage des sources peut également être commandée par un capteur de température (sur le vitrage ou sur les sources de lumière, etc.).

Conformément à la définition de l'invention, outre le substrat (en particulier au moins une feuille de verre transparente) formant la base du vitrage et la ou les sources lumineuses (ou de rayonnement), le vitrage se caractérise par la présence d'un moyen d'extraction sous forme d'au moins une structure fibreuse (ou "textile").

Cette structure fibreuse comprend de préférence des fibres de verre et/ou éventuellement des fibres polymères (ou plastiques). Le verre entrant dans la constitution des fibres peut être de tout type fibrable, notamment le verre E. Dans le cas de fibres polymères, il peut s'agir notamment de fibres de polyester ou de polyoléfine(s) telle que le polyéthylène ou le polypropylène. Les fibres peuvent être de même nature ou non, avoir ou non une même longueur et un même diamètre, la densité et le grammage de la structure pouvant varier.

De manière avantageuse, la structure fibreuse a une masse surfacique comprise entre 10 et 500 g/m², de préférence entre 10 et 100 g/m², et comprend des fibres (textiles) de diamètre compris entre 1 et 20 micromètres, notamment entre 5 et 15 micromètres. De préférence, la structure fibreuse a une épaisseur comprise entre 10 micromètres et 1 millimètre.

La couche fibreuse présente préférentiellement une transmission lumineuse TL supérieure à 45 % et de préférence supérieure à 60 %, la transmission lumineuse étant mesurée sous illuminant D65.

La structure fibreuse peut être tissée ou non tissée ou tricotée (en totalité ou en partie, on peut par exemple tisser des motifs ou former des réseaux de mailles différentes), voire gaufrée (pour avoir un effet 3D), les fibres pouvant former un réseau à maille hexagonale, carrée, en losange, etc. Dans un mode de réalisation avantageux, la structure fibreuse est (choisie parmi) un textile tissé, non tissé ou tricoté, par exemple et avantageusement un voile (ou plusieurs voiles identiques ou différents, de même densité ou non, etc.), ce qui assure une distribution aléatoire des fibres dans la couche extractrice. De manière classique, on entend par voile un non-tissé constitué de filaments complètement dispersés. Avec un tel voile, les propriétés de la couche peuvent être globalement homogènes, notamment en termes de transmission lumineuse. De plus le voile (plus généralement la structure fibreuse) peut être coloré, découpé pour épouser différentes formes (on peut notamment utiliser un emporte-pièces pour couper rapidement un empilement de structures fibreuses, etc.), la surface extractrice pouvant ainsi être continue ou discrétisée, les motifs éclairants pouvant être disposés de manière régulière ou aléatoire d'une pièce à l'autre.

Un voile non tissé de fibres de verre contient généralement un liant (pouvant intégrer un ou des additifs, tels que des pigments à effet dans le visible, l'infrarouge, ou phosphorescents, anti-UV, etc.) qui lie les fibres et confère au voile une rigidité suffisante pour pouvoir être manipulé facilement. Ce liant, qui comprend classiquement au moins un polymère (comme exemplifié ci-après) apte à lier les fibres, est choisi avantageusement transparent (il peut également comprendre un colorant le cas échéant) et peut être de tout type approprié connu. Ce liant ne recouvre préférentiellement qu'une surface limitée des fibres, de telle sorte qu'un rayonnement traversant la couche d'extraction rencontre des interfaces entre les fibres et le liant ou autre milieu d'encapsulation des fibres notamment, comme évoqué par la suite. Le liant représente de préférence environ 5 à 30% en poids du voile (pour un voile de verre notamment), de façon particulièrement préférée de 5 à 20%. On entend par encapsulation des fibres, le fait d'enrober au moins une partie des fibres. Il existe ainsi des interfaces entre le matériau des fibres et le matériau du milieu d'encapsulation.

Outre une structure tissée ou non tissée comme décrites précédemment, la structure fibreuse peut également être formée par des fibres non liées entre elles, par exemple déposées, ou saupoudrées, dans un milieu (notamment une matrice polymère) formant un milieu d'encapsulation en s'emmêlant à la manière d'un voile, ce voile étant alors dépourvu de liant autre que le milieu d'encapsulation.

Avantageusement, le vitrage selon l'invention comprend au moins un substrat transparent, au moins une structure ou couche fibreuse transparente, et le cas échéant au moins un milieu transparent d'encapsulation des fibres de la structure, la valeur absolue de la différence entre l'indice de réfraction des fibres de la structure fibreuse et l'indice de réfraction du milieu d'encapsulation étant de préférence supérieure ou égale à 0,05 pour favoriser la diffusion et l'extraction.

Le milieu d'encapsulation des fibres est avantageusement un matériau polymère. En particulier, il peut être un intercalaire de feuilletage polymère, par exemple à base de polybutyral de vinyle (PVB), d'éthylène vinylacétate (EVA), de polyuréthane, d'un ionomère ou d'un adhésif à base de polyoléfine, ou à base de polymère(s) thermoplastique(s) transparent(s) tel(s) que le polyéthylène téréphtalate (PET), le polyéthylène naphtalate (PEN), le polycarbonate, le polyméthacrylate de méthyle, les polyamides, les polyimides, les polymères fluorés tels que l'éthylène tétrafluoroéthylène (ETFE) et le polytétrafluoroéthylène (PTFE), etc. Selon une variante, ce milieu d'encapsulation peut être formé par de l'air ou par un liquide d'indice de réfraction approprié, au lieu d'une matrice polymère.

Lorsque le milieu d'encapsulation est une matrice polymère, notamment formée par un intercalaire de feuilletage ou un substrat thermoplastique, cette matrice polymère peut présenter une épaisseur supérieure ou égale à l'épaisseur de la structure fibreuse et/ou le cas échéant dépasser d'un côté ou des deux côtés de la structure fibreuse.

Les propriétés d'extraction de la couche fibreuse peuvent être ajustées en jouant sur un ou plusieurs paramètres parmi, notamment, la masse surfacique de la structure fibreuse, le diamètre des fibres, la longueur des fibres, la composition des fibres et celle du milieu d'encapsulation. Un tissu peut être utilisé quand une bonne périodicité et régularité est recherchée. Avantageusement, la couche extractrice a une transmission lumineuse totale supérieure ou égale à 80%, la transmission lumineuse totale, comprenant la transmission lumineuse directe et la transmission lumineuse diffuse, étant déterminée selon la norme ISO 9050:2003. Le cas échéant, la couche extractrice présente également une valeur de flou notamment supérieure ou égale à 40%, la valeur de flou ("haze") d'un élément, exprimée en pourcentage, étant représentative de l'aptitude de cet élément à dévier un rayonnement, les valeurs de flou étant mesurées dans ce cas au hazemeter selon la norme ASTM D 1003.

La structure fibreuse utilisée selon l'invention peut être feuilletée avec les autres éléments (verre, polymère, adhésif...) du substrat, comme illustré ultérieurement.

La couche extractrice peut recouvrir/être agencée (directement) contre une face (notamment principale) du substrat, telle que la face de la feuille externe opposée à la face éclairante, ou d'un élément constitutif (du substrat/du vitrage) (par exemple être appliquée sur au moins une face du guide d'onde) et/ou elle peut se trouver sur ou être intégrée dans le substrat ou élément ou couche rapportée sur une face lorsque celui-ci ou celle-ci est en polymère thermoplastique, avec au moins une partie de ce dernier ou cette dernière formant le milieu d'encapsulation des fibres.

Elle peut être déposée sur une face (élément verrier, intercalaire,...) tournée vers l'intérieur ou l'extérieur, et permet d'augmenter l'extraction des rayons déjà sortants vers la face opposée. Dans le cas d'un substrat/vitrage feuilleté ou éventuellement multiple, la structure fibreuse peut être présente à n'importe quelle interface entre deux matériaux du substrat. La couche fibreuse peut être associée directement (à l'interface verre/air, verre/intercalaire, etc) et/ou rajoutée avec une matière plastique (milieu d'encapsulation) feuilletée avec ledit élément verrier comme déjà évoqué et/ou avec un adhésif (recouvrant le cas échéant une matière plastique) et/ou avec tout élément en contact intime, optique d'une face du guide formant le substrat, etc.

Le moyen d'extraction peut comprendre plusieurs couches fibreuses jointes ou séparées. Lorsque la ou les couches fibreuses sont agencées dans l'épaisseur du substrat et/ou sur une face interne (non tournée vers l'extérieur), elles sont protégées et les faces externes du substrat en contact avec l'environnement extérieur peuvent alors être lisses et aisément nettoyables. Le moyen d'extraction peut aussi comprendre une première couche fibreuse (diffusant dans le visible ou l'UV) et une seconde couche, par exemple externe, à base de particules diffusantes dans le visible et/ou de luminophores excités par l'UV et émettant dans le visible. Des moyens d'extraction supplémentaires peuvent le cas échéant être prévus, par exemple une face extractrice du verre peut aussi être matée, sablée, sérigraphiée etc, ou l'épaisseur du guide peut également être gravée, etc.

La ou les couches fibreuses utilisées comme moyen d'extraction peuvent couvrir une partie ou la totalité d'une ou plusieurs faces selon l'éclairage ou l'effet recherché (elles peuvent être sous forme de bandes disposées en périphérie d'une des faces pour former un cadre lumineux, peuvent former des logos ou motifs, etc.). Pour fournir un éclairage homogène, la fraction surfacique recouverte par les fibres peut croître avec l'éloignement de la source lumineuse, étant par exemple de 5% près de la source et de 16% à 55% loin de la source.

Le moyen (zone, surface) d'extraction peut être en plusieurs morceaux, par exemple des motifs, identiques ou distincts, continus ou discontinus, et peut être de toute forme géométrique (rectangulaire, carré, en triangle, circulaire, ovale, etc.), et peut former un dessin, un signalétique (flèche, lettre...). On peut facilement obtenir une délimitation des zones contrôlable et reproductible industriellement. Le vitrage peut ainsi comprendre plusieurs zones (couches fibreuses) d'extraction pour former plusieurs zones lumineuses sur le vitrage. Comme déjà évoqué, la ou les zones lumineuses peuvent couvrir une partie ou l'ensemble de la surface (fonctionnelle, visible) d'un élément extérieur du vitrage. Plusieurs zones peuvent être lumineuses simultanément ou non, être pilotées indépendamment ou non. Le vitrage peut être à éclairage différencié, par exemple produisant à la fois un éclairage architectural et décoratif, ou un éclairage architectural et de signalisation, ou un éclairage architectural et un affichage (par exemple du type dessin, logo, signalisation alphanumérique, etc), ou un éclairage de lecture, etc. Des jeux de couleurs peuvent en outre être obtenus en fonction des sources de lumière (en particulier des LEDs) mais également en colorant les fibres de la structure fibreuse.

De préférence, la majorité, voire au moins 80% ou 90% des rayons (en particulier arrivant sur la zone de la couche fibreuse) sont extraits par la couche fibreuse. L'avantage d'une distribution discrète ou aléatoire des fibres est d'obtenir un guide transparent lorsque la source lumineuse est éteinte, au travers duquel on peut voir distinctement (possibilité de reconnaître et d'identifier des formes telles que des visages, des symboles), ceci étant particulièrement intéressant pour les applications automobiles.

Dans un mode de réalisation, lorsque la source de lumière est éteinte, le vitrage est transparent ou globalement (du fait du maillage des fibres) transparent, notamment de transmission lumineuse T_{L} supérieure à 20 %, de préférence supérieure ou égale à 50 %, voire supérieure ou égale à 70 %, et de réflexion lumineuse R_{L} inférieure ou égale à 50 %, de préférence inférieure ou égale à 30 % (cas par exemple d'une fenêtre éclairante, l'amélioration de l'éclairage de la pièce n'étant pas réalisée au détriment de la transmission lumineuse).

Dans un autre mode de réalisation, lorsque la source de lumière est éteinte, le vitrage peut être semi réfléchissant ou réfléchissant, former un miroir (au moyen d'un miroir rapporté sur l'une des faces du substrat, feuille métallique, plaque en inox par exemple, ou d'une couche métallique, notamment en argent, sur l'une des faces du substrat (généralement opposée à la face lumineuse/extractrice), le vitrage pouvant aussi former un miroir lorsque la source est allumée.

Une ou plusieurs autres zones peuvent en effet être également présentes sur l'un et/ou l'autre des éléments du vitrage, par exemple : une zone (semi) transparente, et/ou une zone réfléchissante formant miroir (par dépôt d'un revêtement réfléchissant), avec le cas échéant un moyen diffusant supplémentaire formé par attaque du miroir, et/ou une zone translucide, satinée (préservation de l'intimité, etc.) par exemple par texturation d'un élément verrier, et/ou une zone décorative, par un revêtement opaque et/ou coloré ou par un élément verrier teinté dans la masse, etc.

Le vitrage selon la présente invention satisfait aux exigences industrielles (en termes de rendement, de coût, de cadence, d'automatisation...), rendant ainsi possible une production « bas coût » sans sacrifier les performances. Il peut être utilisé aussi bien en extérieur qu'en intérieur.

Dans un mode de réalisation préféré,le vitrage selon l'invention comprend :
- au moins une feuille de verre transparente (formant le substrat ou une partie du substrat ou fixée au ou à un substrat (formé d'au moins un autre élément verrier préférentiellement transparent), par exemple par l'intermédiaire d'un intercalaire de feuilletage), dite feuille guide d'onde,
- au moins une source de rayonnement, positionnée (au bord du vitrage) de manière à éclairer la feuille guide d'onde par la tranche de celle-ci,
- au moins un moyen d'extraction du rayonnement, ce moyen d'extraction étant formé par (une structure fibreuse choisie parmi) un textile tissé, non tissé ou tricoté, appliqué sur au moins une face de la feuille guide d'onde.

Dans un mode de réalisation simple, le vitrage peut comporter par exemple une structure feuilletée composée d'une feuille externe (destinée à être éclairée), d'une feuille centrale transparente de guidage de lumière (feuille guide d'onde), et d'une couche interne de fibres telle que précédemment décrite. La source de lumière est une pluralité de diodes électroluminescentes montées sur un support latéral fixé à la tranche des feuilles du feuilleté, un trou étant le cas échéant pratiqué dans la feuille centrale pour loger les diodes.

Outre les éléments déjà cités, le vitrage peut également comporter d'autres éléments et/ou couches, par exemple un réflecteur de lumière (une pièce fixée le cas échéant dans l'espace interne avec une surface réfléchissante, les rayons centraux étant renvoyés vers une face grâce au réflecteur, ceci assurant le cas échéant un meilleur rendement optique et/ou ce réflecteur recyclant la lumière rétrodiffusée par des moyens diffusants et/ou réfléchie sur la ou les embases des diodes et/ou réfléchie sur un espaceur. Le vitrage peut également comprendre une ou des résines adhésives transparentes (pour le collage des éléments, par exemple une couche formant un adhésif externe, notamment en un matériau ramolli par chauffage pour devenir adhésif (PVB par exemple) ou en un matériau avec des faces adhésives comme le PE, PU, PET), une couche (feuille, film, dépôt...) protectrice (par exemple un film souple en PU, PE, silicone éventuellement collé par acrylique) en bordure d'une face ou s'étendant sur ladite face, une couche (le cas échéant électroconductrice) avec une ou des fonctions telles que : protection aux rayonnements (IR, UV), contrôle solaire, basse émissivité, anti rayures, esthétique (teinte, motifs, etc), etc. Le vitrage selon l'invention présente l'avantage d'être compatible avec l'utilisation d'autres couches, ceci étant particulièrement intéressant dans le cas des applications automobiles.

Il peut ainsi être avantageux d'incorporer dans le vitrage ou sur un de ses éléments un revêtement à fonction donnée, par exemple de blocage des rayonnements dans l'infrarouge (par exemple à base de couches d'argent entourées de couches en diélectrique, ou des couches en nitrures comme TiN ou ZrN ou en oxydes métalliques ou en acier ou en alliage Ni-Cr), ou à fonction basse émissivité (par exemple en oxyde de métal dopé comme SnO₂:F ou oxyde d'indium dopé à l'étain (ITO) ou une ou plusieurs couches d'argent), ou anti-buée (couche hydrophile), ou anti-salissures (revêtement photocatalytique comprenant du TiO₂ au moins partiellement cristallisé sous forme anatase), ou encore un empilement anti-reflet du type par exemple Si₃N₄/SiO₂/Si₃N₄/SiO₂, une couche hydrophobe/oléophobe, oléophile, un empilement réfléchissant le rayonnement thermique (contrôle solaire) ou infra rouge (bas-émissif), etc. Le module peut ainsi intégrer toutes fonctionnalités connues dans le domaine du vitrage.

On peut également avoir des surfaces texturées, notamment sablées ou acidées, sérigraphiées pour des raisons esthétiques ou fonctionnelles (par exemple empêcher un éblouissement, etc.

Le vitrage selon l'invention peut être utilisé pour former un éclairage décoratif, de lecture, architectural, de signalisation, d'affichage, etc. Il peut être par exemple :
- avantageusement destiné à un véhicule automobile ou de transport, comme toit vitré lumineux ou fenêtre (lunette arrière, vitre latérale, pare-brise) lumineuse, porte vitrée lumineuse, notamment de transport en commun, train, métro, tramway, bus ou de véhicule aquatique ou aérien (avion), à l'éclairage routier ou urbain,
- destiné à former un vitrage de bâtiment, comme une façade éclairante (ou lumineuse), une fenêtre éclairante, un plafonnier, une dalle de sol ou murale lumineuse, une porte vitrée lumineuse, une cloison lumineuse, une marche d'escalier,
- destiné au mobilier urbain, comme une partie vitrée lumineuse d'abribus, de balustrade, de présentoir, d'une vitrine, un élément d'étagère, une serre, un étalage de bijouterie, un aquarium, un garde corps, une contre marche, une plinthe,
- destiné à l'ameublement intérieur, comme une paroi lumineuse de salle de bains, un miroir lumineux, une partie vitrée lumineuse d'un meuble, un plan de travail de cuisine, une crédence, un fond de hotte, un carrelage de sol ou mural, un élément de réfrigérateur (tablette..),
- destiné à tout équipement domestique ou professionnel de réfrigération ou de congélation ou de cuisson (comme des plaques de vitrocéramique), etc.

On peut également parler d'utilisation comme les lampes planes, ces lampes planes pouvant être une source de lumière ou « back-light » utilisée dans des ordinateurs à écrans plats pour fournir l'éclairage d'un écran à cristaux liquides, ou utilisées sur des plafonds, des sols, ou des murs, ou des lampes pour panneaux publicitaires ou des lampes pouvant constituer des étagères ou des fonds de vitrines d'exposition, etc. On parle généralement de lampe plane lorsque le vitrage est constitué de deux substrats substantiellement plans, tels que des feuilles de verre, sur lesquels sont déposées différentes couches constitutives de la lampe (par exemple des électrodes d'argent recouvertes d'un diélectrique, des couches d'alumine et de phosphore, etc).

L'éclairage/l'extraction peut être ajustée pour un éclairage d'ambiance, de lecture, une signalisation lumineuse, un éclairage de nuit ou d'affichage d'informations de toutes natures, de type dessin, logo, signalisation alphanumérique ou autres signalétiques, et peut aussi être activée par télécommande (détection du véhicule dans un parking ou autre, indicateur de (dé)verrouillage de portes), signalisation de sécurité, etc. La lumière peut être continue et/ou par intermittence, monochromatique et/ou plurichromatique, blanche, etc.

Le vitrage présente un éclairage avec une bonne homogénéité et une efficacité d'extraction satisfaisante. L'insertion du textile fournit une délimitation des zones aisément contrôlable et reproductible industriellement et une extraction plus facile à maitriser, la robustesse des diodes étant également intéressante dans des utilisations intensives. Comme déjà signalé, l'utilisation de la structure fibreuse comme surface extractrice dans les applications vitrages automobiles est en outre compatible avec l'utilisation de couches minces sur le verre et avec les lignes de production ne disposant pas de sérigraphie, elle permet également d'avoir un rendu et un esthétisme non réalisable avec d'autres moyens d'extraction et est compatible avec les exigences de vitrages à surfaces lisses extérieures. Elle participe en outre au renforcement du vitrage si elle est utilisée sur une surface importante.

L'invention porte aussi sur un véhicule incorporant (ou comprenant) le vitrage défini précédemment.

L'invention vise enfin un procédé de fabrication du vitrage tel que défini précédemment comprenant l'ajout d'au moins une structure, en particulier une couche, fibreuse dans le vitrage.

Selon un premier mode de réalisation, la couche est déposée sur la face d'un élément du substrat (feuille de verre par exemple) orientée vers l'intérieur du vitrage. La couche peut être déposée directement sur le verre ou bien sur les couches déjà déposées sur le verre. Selon un autre mode de réalisation, la couche est déposée sur la face orientée vers l'extérieur. On peut également réaliser un dépôt d'une couche fibreuse de chaque côté d'un élément du substrat.

La structure fibreuse peut également être incorporée combinée ou encapsulée avec/dans une ou des autres couches, en particulier plastiques et/ou adhésives. Dans le cas où le milieu d'encapsulation est formé par un polymère thermoplastique transparent, l'encapsulation des fibres de la structure fibreuse dans le substrat thermoplastique peut être réalisée au cours du moulage, en positionnant la structure fibreuse dans un moule puis en injectant le polymère thermoplastique (par exemple un polycarbonate) dans le moule. Alternativement, une fois préparée, la couche fibreuse peut être encastrée dans une couche plastique (par exemple de PVB), par compression de la couche fibreuse contre la couche plastique. L'ensemble comprenant la couche plastique et la couche fibreuse encastrée dans ladite couche est ensuite mis en place dans le vitrage, de la même manière que pour un intercalaire de feuilletage classique, et cette structure laminée est passée à l'étuve de manière à obtenir une bonne cohésion entre les différentes couches constitutives du vitrage.

Dans le cas de l'utilisation d'un voile de fibres de verre, ce voile peut être formé selon un procédé opérant par « voie sèche », ou selon un procédé opérant par « voie humide ». De tels procédés de fabrication de voiles de fibres de verre étant bien connus de l'homme du métier, ils ne sont pas décrits plus en détails ici.

La présente invention sera mieux comprise et d'autres détails et caractéristiques avantageuses de l'invention apparaitront à la lecture des exemples de vitrages lumineux selon l'invention illustrés par les figures suivantes :
- Les figures 1a, 1b et 1c représentent respectivement des vues schématiques en coupe et de face d'un vitrage dans un premier mode de réalisation de l'invention ;
- les figures 2 à 6 représentent différentes vues schématiques en coupe de différents vitrages selon l'invention ;

On précise que par un souci de clarté les différents éléments des objets représentés ne sont pas nécessairement reproduits à l'échelle.

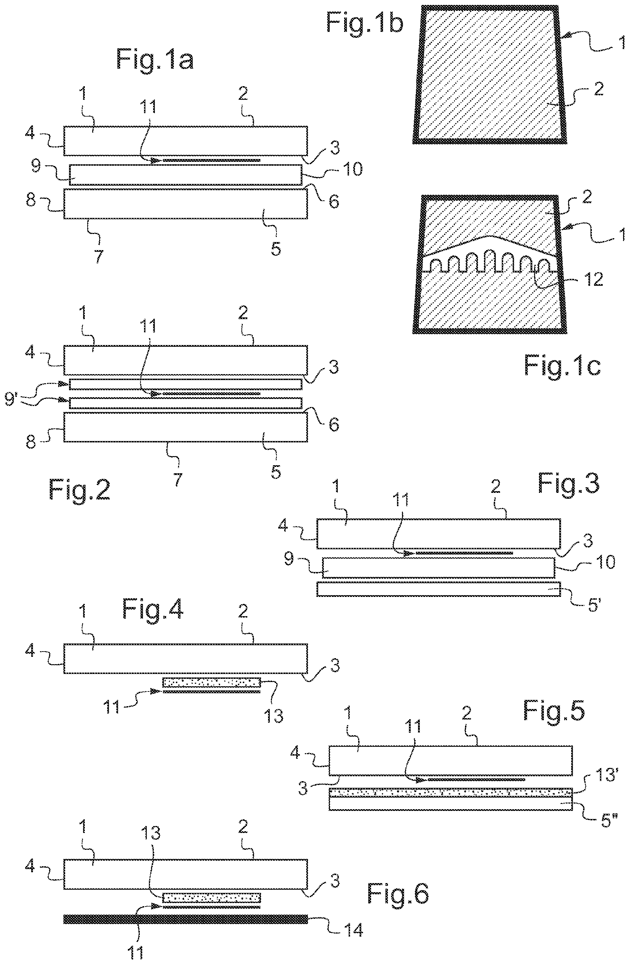

Dans la figure 1, le vitrage selon l'invention est un vitrage feuilleté comportant comme substrat:
- une première feuille transparente 1, par exemple rectangulaire (de dimensions 300X300 mm par exemple), en verre minéral, présentant une première face principale 2 et une deuxième face principale 3, et une tranche 4 de préférence arrondie (pour éviter les écailles), par exemple une feuille de verre silicosodocalcique de type planilux (commercialisée par la société Saint-Gobain Glass), d'épaisseur égale par exemple à 2,1 mm,
- une deuxième feuille de verre 5, de même composition et dimensions, ou éventuellement avec une composition pour une fonction de contrôle solaire teintée (verre VENUS VG10 ou TSA 4+ commercialisée par la société Saint-Gobain Glass par exemple) et/ou recouverte d'un revêtement de contrôle solaire, avec une face principale 6 en regard de la face 3, et une autre face principale 7, et une tranche 8.

La deuxième feuille de verre est feuilletée par un intercalaire de feuilletage 9, par exemple un PVB clair d'épaisseur 0,76 mm, comportant une tranche 10. Les feuilles de verre du substrat présentent de préférence un coefficient d'absorption linéique inférieur ou égal à 2,5 m⁻¹ dans le visible (par exemple verre sodocalcique extraclair, de coefficient d'absorption linéique inférieur à 0,7 m⁻¹ dans le visible ou le proche UV).

Un profilé support de diodes électroluminescentes (non représentés) s'étend en bordure du vitrage et est fixé à la première feuille de verre (destinée par exemple à être la feuille interne placée dans l'habitacle d'un véhicule et comportant le cas échéant une encoche) sur la tranche 4 (la face émettrice des sources étant en vis à vis de la tranche et une colle étant déposée le cas échéant sur les puces pour assurer l'étanchéité lors de l'encapsulation). Ce support peut être monolithique métallique (inox, aluminium) ou par exemple en polyimide avec couches, mince, d'épaisseur égale à 0,2 mm. Les diodes de chaque groupe ont chacune une direction principale d'émission donnée sensiblement parallèle à la première face, par exemple à équidistance des première et troisième faces. A titre d'exemple, les diodes (une vingtaine) ont une puissance individuelle de 0,4 W (environ), sur une longueur L0 de 450 mm, soit une puissance de 20,5 W/m.

Une couche fibreuse d'extraction 11 est intercalée entre la première feuille et l'intercalaire (et est appliquée par exemple sur la première feuille formant guide d'onde). Le rayonnement est guidé notamment dans l'épaisseur de la feuille 1 par réflexions et est extrait de la première face 2 au moyen de la couche fibreuse. La couche fibreuse est avantageusement un voile transparent de fibres de verre de type E. Un exemple de voile de fibres de verre susceptible d'être utilisé pour le voile est un voile du type U50 commercialisé par Saint-Gobain Technical Fabrics, qui présente un grammage, ou masse surfacique, de 50 g/m².

Le vitrage de la figure 1 peut former par exemple un toit panoramique fixe de véhicule terrestre, monté par l'extérieur, la première feuille étant du côté intérieur du véhicule, et l'extraction étant de préférence par la face 2 (orientée par exemple vers l'habitacle d'un véhicule). Lorsque les diodes sont éteintes, le vitrage lumineux est globalement transparent (figure 1b), de transmission lumineuse globale T_{L} de l'ordre de 85% et de réflexion lumineuse R_{L} de l'ordre de 15%. Lorsque les diodes sont allumées, l'extraction peut former un dessin lumineux 12, par exemple un logo ou une marque, comme représenté en figure 1c, le voile étant en effet taillé suivant le motif voulu pour créer la signalétique désirée.

Le vitrage peut aussi en variante avoir une pluralité de zones de lumière, et/ou une ou des zones lumineuses en une ou d'autres faces, la ou les zones lumineuses occupant de préférence au moins 50 %, voire 80 % de la surface d'au moins une face, étant de géométrie donnée (rectangulaire, carré, rond ...) et/ou régulièrement réparties pour fournir un éclairage décoratif. Il a généralement avantageusement une seule face éclairante 2, constituant par exemple un luminaire. On peut aussi disposer un miroir en regard du contre verre. Le vitrage peut ainsi servir de miroir (notamment lorsque le vitrage est destiné à des applications bâtiments) le jour et de source d'éclairement la nuit.

Dans la figure 2 le vitrage diffère du précédent par les caractéristiques techniques suivantes :
- le verre 1 est feuilleté avec le verre 5 (éventuellement de dimensions ou formes différentes), au moyen de deux intercalaires 9' (ou parties d'intercalaire du même intercalaire comme décrit ci-après) de feuilletage tels que du PVB, de préférence (extra)clair (ou un clair et un teinté), et d'épaisseur de 0.38 mm chacun, entre lesquels se trouve la structure fibreuse. Alternativement la structure fibreuse peut être noyée/encapsulée dans un intercalaire unique tel que celui décrit dans les figures précédentes et/ou une matrice transparente en PVB, dont l'indice de réfraction n₄ est de l'ordre de 1,48, peut encapsuler le voile décrit en figure 1. Ainsi, la différence d'indice de réfraction entre les fibres du voile et la matrice est de l'ordre de 0,09. La matrice polymère encapsule le voile en ayant sensiblement la même épaisseur que celui-ci. Toutefois, elle peut présenter une épaisseur supérieure à l'épaisseur du voile, celui-ci étant alors encapsulé dans une partie seulement de la matrice polymère. La différence d'indice de réfraction entre les fibres du voile et la matrice d'encapsulation contribue à l'extraction du rayonnement à l'interface entre les fibres du voile et la matrice. L'extraction liée au flou du voile en même temps que la bonne transmission lumineuse de la couche au repos peuvent être ajustées en jouant sur un ou plusieurs paramètres parmi, notamment, le grammage du voile, le diamètre des fibres du voile, la composition des fibres du voile, la composition de la matrice polymère, de manière à obtenir une couche réalisant un compromis avantageux entre flou et transmission lumineuse. L'utilisation d'une matrice d'encapsulation en PVB, ou en tout autre intercalaire de feuilletage polymère, est également avantageuse pour assurer le maintien du voile ou d'autres couches fonctionnelles entre les éléments verriers. Ce mode présente différents avantages, ne posant pas notamment de problème d'adhésion entre le PVB et le verre des fibres par exemple.

Dans la figure 3 le vitrage diffère de celui de la figure 1 par le fait que la deuxième feuille 5' est un film polymère.

Dans la figure 4 le vitrage diffère de celui de la figure 1 par l'absence de deuxième feuille et d'un intercalaire, la structure fibreuse étant positionnée sur une face de la feuille de verre 1 à l'aide d'un adhésif 13 et/ou le cas échéant recouverte de celui-ci.

Dans la figure 5 le vitrage diffère du précédent en ce que l'adhésif 13' recouvre un film polymère 5", le voile 11 étant intercalé entre l'ensemble adhésif/polymère et la feuille de verre 1, ce mode de réalisation étant utilisé dans le domaine automobile.

Dans la figure 6 le vitrage diffère de celui de la figure 4 en ce que un vernis 14 de protection est ajouté sur le voile 11 et le cas échéant sur le reste de la face du vitrage non couverte par le voile.

Le vitrage selon l'invention peut servir dans de multiples applications, en particulier dans l'automobile (généralement sous forme d'un vitrage feuilleté ou monolithique), mais aussi éventuellement dans le bâtiment, intérieur comme extérieur (en particulier sous forme d'un vitrage isolant multiple, par exemple pour l'éclairage de façades de bâtiments ...), les lampes planes, etc.

## Revendications

1. Vitrage lumineux ou éclairant comprenant :
- au moins un substrat, formé d'au moins un élément verrier préférentiellement transparent,
- au moins une source de rayonnement,
- au moins un moyen d'extraction du rayonnement, ce moyen d'extraction étant formé par au moins une structure textile tissée ou non-tissée ou tricotée ou gaufrée,
ledit rayonnement étant guidé dans au moins une partie guide d'onde formée d'au moins une feuille.

2. Vitrage lumineux selon la revendication 1, **caractérisé en ce qu'**il comprend des diodes électroluminescentes comme sources de rayonnements.

3. Vitrage lumineux selon l'une des revendications 1 ou 2, **caractérisé en ce qu'**il est éclairé par la tranche.

4. Vitrage lumineux selon l'une des revendications 1 à 3, **caractérisé en ce que** le moyen d'extraction, ou la structure fibreuse, est, ou est formé(e), d'au moins un voile de fibres, en particulier un voile de fibres de verre ou éventuellement de fibres plastiques.

5. Vitrage lumineux selon l'une des revendications 1 à 4, **caractérisé en ce que** le moyen d'extraction comporte en outre au moins un milieu d'encapsulation des fibres et /ou un adhésif.

6. Vitrage lumineux selon l'une des revendications 1 à 5, **caractérisé en ce qu'**il comprend au moins une diode réceptrice de signaux de commande et/ou **en ce que** la ou les sources de rayonnement sont couplées à des moyens de pilotage et/ou **en ce qu'**un ou des capteurs liés à l'environnement et/ou au vitrage sont associées à la ou aux sources de rayonnement.

7. Vitrage lumineux ou éclairant, en particulier selon l'une des revendications 1 à 6, comprenant:
- au moins une feuille de verre transparente, dite feuille guide d'onde,
- au moins une source de rayonnement, positionnée de manière à éclairer la feuille guide d'onde par la tranche de celle-ci,
- au moins un moyen d'extraction du rayonnement, ce moyen d'extraction étant formé par un textile tissé, non tissé ou tricoté, appliqué sur au moins une face de la feuille guide d'onde.

8. Vitrage lumineux selon la revendication 7, **caractérisé en ce que** la feuille guide d'onde est fixée, par l'intermédiaire d'un intercalaire de feuilletage, à un substrat formé d'au moins un élément verrier transparent.

9. Véhicule automobile incorporant un vitrage lumineux selon l'une des revendications 1 à 8.

## Patentansprüche

1. Leuchtende oder beleuchtende Verglasung, umfassend:
- mindestens ein Substrat, gebildet aus mindestens einem vorzugsweise transparenten Glaselement,
- mindestens eine Strahlungsquelle,
- mindestens ein Mittel zur Extraktion der Strahlung, wobei dieses Extraktionsmittel aus mindestens einer gewebten oder nicht gewebten oder gewirkten oder geprägten Textilstruktur gebildet ist, wobei die Strahlung durch mindestens einen Wellenleiterabschnitt geführt wird, der aus mindestens einer Folie gebildet ist.

2. Leuchtende Verglasung nach Anspruch 1, **dadurch gekennzeichnet, dass** die Verglasung Leuchtdioden als Strahlungsquellen umfasst.

3. Leuchtende Verglasung nach einem der Ansprüche 1 oder 2, **dadurch gekennzeichnet, dass** sie durch die Schmalseite beleuchtet wird.

4. Leuchtende Verglasung nach einem der Ansprüche 1 bis 3, **dadurch gekennzeichnet, dass** das Extraktionsmittel oder die Faserstruktur mindestens ein Faservlies, insbesondere ein Glasfaservlies oder gegebenenfalls ein Kunststofffaservlies, ist oder daraus gebildet ist.

5. Leuchtende Verglasung nach einem der Ansprüche 1 bis 4, **dadurch gekennzeichnet, dass** das Extraktionsmittel ferner mindestens ein Faserverkapselungsmedium und/oder einen Klebstoff umfasst.

6. Leuchtende Verglasung nach einem der Ansprüche 1 bis 5, **dadurch gekennzeichnet, dass** sie mindestens eine Empfängerdiode für Steuersignale umfasst und/oder dass die eine oder mehrere Strahlungsquellen mit Steuermitteln gekoppelt sind und/oder dass ein oder mehrere Sensoren, die mit der Umgebung und/oder der Verglasung verbunden sind, der oder den Strahlungsquellen zugeordnet sind.

7. Leuchtende oder beleuchtende Verglasung, insbesondere nach einem der Ansprüche 1 bis 6, umfassend:
- mindestens eine Folie aus transparentem Glas, die sogenannte Wellenleiterfolie,
- mindestens eine Strahlungsquelle, die so angeordnet ist, dass sie die Wellenleiterfolie durch deren Schmalseite beleuchtet,
- mindestens ein Mittel zur Extraktion der Strahlung, wobei dieses Extraktionsmittel aus einem gewebten, nicht gewebten oder gewirktem Textil gebildet ist und auf mindestens eine Seite der Wellenleiterfolie aufgebracht ist.

8. Leuchtende Verglasung nach Anspruch 7, **dadurch gekennzeichnet, dass** die Wellenleiterfolie über eine Laminierzwischenschicht auf einem Substrat, das aus mindestens einem transparenten Glaselement gebildet ist, befestigt ist.

9. Kraftfahrzeug, enthaltend eine leuchtende Verglasung nach einem der Ansprüche 1 bis 8.

## Claims

1. An illuminating or luminous glazing unit comprising:
- at least one substrate, formed by at least one preferably transparent glazing element;
- at least one light source; and
- at least one means for extracting the light, this extraction means being formed by at least one woven or nonwoven or knitted or embossed textile structure,
said light being guided in at least one waveguide part formed by at least one sheet .

2. The luminous glazing unit as claimed in claim 1, **characterized in that** it comprises light-emitting diodes as light sources.

3. The luminous glazing unit as claimed in either of claims 1 and 2, **characterized in that** it is illuminated via the edge face.

4. The luminous glazing unit as claimed in one of claims 1 to 3, **characterized in that** the extraction means, or the fibrous structure, is, or is formed by, at least one fibers veil, in particular a glass-fibers veil or optionally a plastic fibers veil.

5. The luminous glazing unit as claimed in one of claims 1 to 4, **characterized in that** the extraction means furthermore comprises at least one medium encapsulating the fibers and/or an adhesive.

6. The luminous glazing unit as claimed in one of claims 1 to 5, **characterized in that** it comprises at least one diode that receives command signals and/or **in that** the one or more light sources are coupled to piloting means and/or **in that** one or more sensors connected to the environment and/or to the glazing unit are associated with the one or more light sources.

7. The illuminating or luminous glazing unit, in particular as claimed in one of claims 1 to 6, comprising:
- at least one transparent glass sheet, called the waveguide sheet;
- at least one light source, positioned so as to illuminate the waveguide sheet via the edge face of the latter; and
- at least one means for extracting the light, this extraction means being formed by a woven, nonwoven or knitted textile placed on at least one face of the waveguide sheet.

8. The luminous glazing unit as claimed in claim 7, **characterized in that** the waveguide sheet is fixed, by way of a lamination interlayer, to a substrate formed by at least one transparent glazing element.

9. An automotive vehicle incorporating a luminous glazing unit as claimed in one of claims 1 to 8.
